(19)

Europäisches Patentamt
European Patent Office
Office européen des brevets

(11) **EP 4 738 007 A1**

(12) **EUROPEAN PATENT APPLICATION**

(43) Date of publication:
06.05.2026 Bulletin 2026/19

(21) Application number: 24210525.2

(22) Date of filing: 04.11.2024

(51) International Patent Classification (IPC):
*G03F 7/00* (2006.01)

(52) Cooperative Patent Classification (CPC):
G03F 7/706837

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: ASML Netherlands B.V.
5500 AH Veldhoven (NL)

(72) Inventors:
• TINNEMANS, Patricius, Aloysius, Jacobus
5500 AH Veldhoven (NL)

• VAN PUTTEN, Eibert, Gerjan
5500 AH Veldhoven (NL)
• COENE, Willem, Marie, Julia, Marcel
5500 AH Veldhoven (NL)
• EL GAWHARY, Omar
5500 AH Veldhoven (NL)
• NIENHUYS, Han-Kwang
5500 AH Veldhoven (NL)
• PORTER, Christina, Lynn
5500 AH Veldhoven (NL)

(74) Representative: ASML Netherlands B.V.
Corporate Intellectual Property
P.O. Box 324
5500 AH Veldhoven (NL)

(54) **METROLOGY METHOD AND ASSOCIATED METROLOGY DEVICE**

(57)      Disclosed is a method of metrology comprising: obtaining measurement data relating to scattered radiation, having been scattered by a structure of interest and captured on at least one detector; determining at least a magnitude of a derivative of the phase of at least one component of said scattered radiation from said intensity; and determining at least one parameter of interest of said structure of interest from said at least the magnitude of the derivative of the phase.

Fig. 8

EP 4 738 007 A1

**Description**

FIELD

The present invention relates to a metrology method and device which may, for example, be used for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

In many metrology applications, it is desirable to access the full electric field (i.e., intensity and phase) rather than only intensity. Holography tools enable this, however they require a reference beam and very stringent operation to ensure interference between the reference beam and measurement radiation beam. Other phase retrieval methods may comprise an iterative retrieval of phase, however these are computationally demanding,

It would be desirable to improve on present methods for measuring the full electric field in metrology applications.

SUMMARY

Embodiments of the invention are disclosed in the claims and in the detailed description. In a first aspect of the invention there is provided a method of metrology comprising: obtaining measurement data relating to scattered radiation, having been scattered by a structure of interest and captured on at least one detector; determining at least a magnitude of a derivative of the phase of at least one component of said scattered radiation from said intensity; and determining at least one parameter of interest of said structure of interest from said at least the magnitude of the derivative of the phase.

These and other aspects and advantages of the apparatus and methods disclosed herein will be appreciated from a consideration of the following description and drawings of exemplary embodiments.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;

- Figure 2 depicts a schematic overview of a lithographic cell;

- Figure 3 depicts a schematic representation of holistic lithography, representing a cooperation between three key technologies to optimize semiconductor manufacturing;

- Figure 4 is a schematic illustration of a scatterometry apparatus;

- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements (d) a third pair of illumination apertures combining the first and second pair of apertures;

- Figure 6 depicts a schematic representation of a metrology apparatus in which EUV and/or SXR radiation is used;

- Figure 7 depicts a simplified schematic drawing of an illumination source such as may be used in the metrology apparatus of Figure 6;

- Figure 8 depicts schematically an example dark field digital holographic microscope;

- Figure 9 depicts a simplified schematic drawing of a measurement of a structure using the metrology apparatus of Figure 6;

- Figure 10 is a flowchart describing a method of metrology according to embodiments disclosed herein; and

- Figure 11 depicts a block diagram of a computer system for controlling a metrology method and/or device such as disclosed herein.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

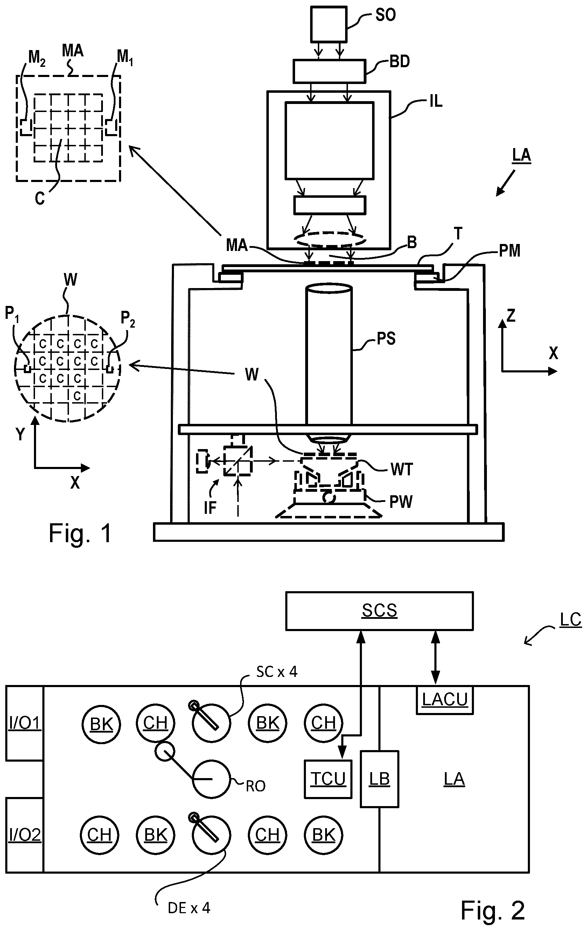

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

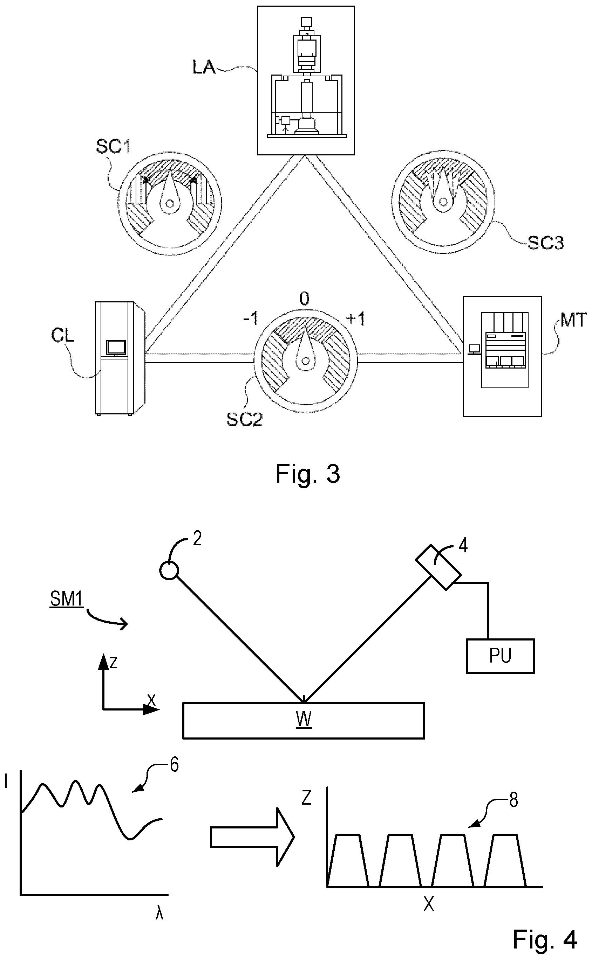

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety. Other parameters of interest may be focus and dose. Focus and dose may be determined simultaneously by scatterometry (or alternatively by scanning electron microscopy) as described in US patent application US2011-0249244, incorporated herein by reference in its entirety.

The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

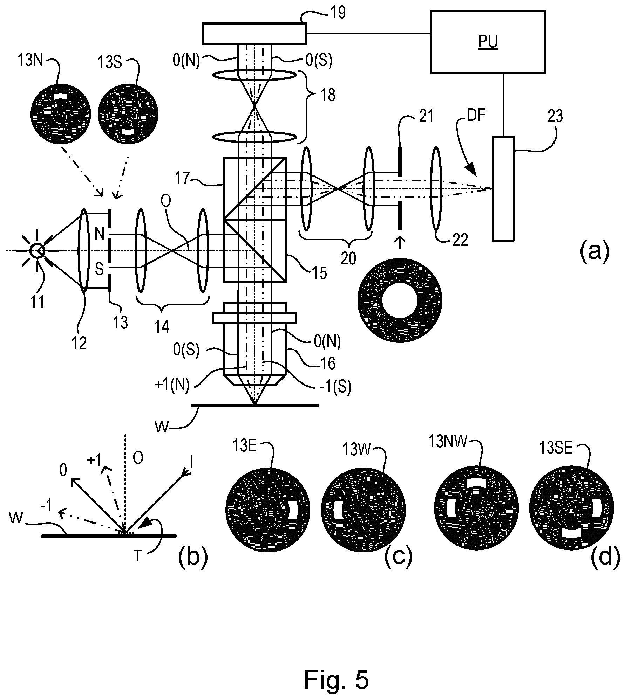

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 11 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane or angularly resolved plane. In particular, this can be done by inserting an aperture plate 13 of suitable form between lenses 12 and 11, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

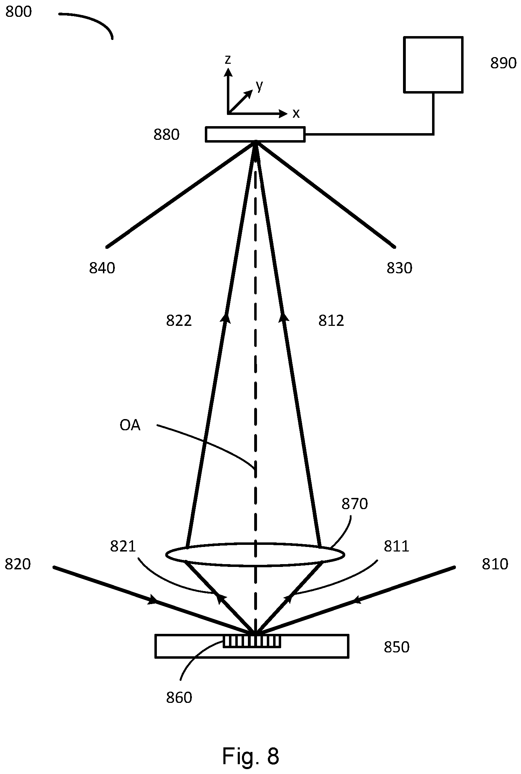

The measurement radiation used in a metrology device such as illustrated in Figure 5(a) (and of a DHM such as illustrated in Figure 8, described below) may comprise visible wavelengths, e.g., one or more wavelengths within the range of 400nm to 900nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

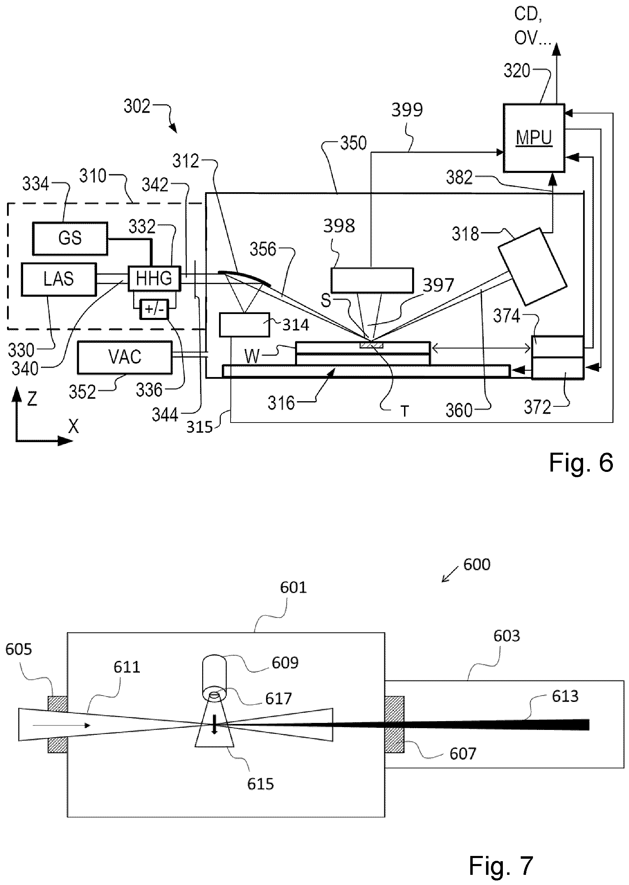

Figure 6 depicts a schematic representation of a metrology apparatus 302 in which the aforementioned radiation may be used to measure parameters of structures on a substrate. The metrology apparatus 302 may comprise a spectroscopic scatterometer using hard X-ray, Soft X-Ray and/or EUV radiation optionally in grazing incidence, purely by way of example.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to $10\mu m$, for example in the region of $1 \mu m$ (1 micron). Optionally, the laser pulses are delivered as a first pump radiation 340 to the gas delivery system 332, wherein a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N2), Oxygen (02), Argon (Ar), Krypton (Kr), Xenon (Xe), Carbon dioxide or any combination of these. These gasses may be selectable options within the same apparatus. The emitted radiation 342 may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore, to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam may enter an inspection chamber 350 where the substrate W including a structure of interest is held for inspection at a measurement position by substrate support 316. The structure of interest (or target) is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu m$ in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the structure of interest T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the structure of interest T has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the structure of interest T are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N2), Oxygen (02), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminum plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 (and/or the measurement radiation for any of the embodiments disclosed herein) may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV, SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV, SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting a complementary pair of diffraction orders such as the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

As an alternative to a scatterometer such as depicted in Figure 5(a) or Figure 6, a metrology device may comprise a holographic microscope such as a digital holographic microscope (DHM) or digital dark-field holographic microscope. Such as device is disclosed, for example, in US2019/0107781 and WO2021121733A1 both of which is incorporated herein by reference.

Figure 8 schematically illustrates the imaging branch of a dark field digital holographic microscope (df-DHM) 800 in accordance with an embodiment. A dark field digital holographic microscope (df-DHM) comprises an imaging branch and an illumination branch. In this embodiment, a metrology target 860 comprising a structure on a substrate 850 is illuminated by two illumination beams of radiation, i.e., a first illumination beam of radiation 810 and a second illumination beam of radiation 820. In an embodiment, such two illumination beams 810, 820 may simultaneously illuminate the metrology target 860.

In an embodiment, the first illumination beam 810 may be incident on the metrology target 860 at a first angle of incidence in a first direction with respect to the optical axis OA. The second illumination beam 820 may be incident on the metrology target 860 at a second angle of incidence in a second direction with respect to the optical axis OA. The first angle of incidence of the first illumination beam 810 and the second angle of incidence of the second illumination beam 820 may be substantially the same. The angle of incidence of each illumination beam may be, for example in the range of 70 degrees to 90 degrees, in the range of 50 degrees to 90 degrees, in the range of 30 degrees to 90 degrees, in the range of 10 degrees to 90 degrees. The illumination of the metrology target 860 may result in radiation being scattered from the target. In an embodiment, the first illumination beam 810 may be incident on the metrology target 860 at a first azimuthal angle, corresponding to the first direction. The second illumination beam 820 may be incident on the metrology target 860 at a second azimuthal angle, corresponding to the second direction. The first azimuthal angle of the first illumination beam 810 and the second azimuthal angle of the second illumination beam 820 may be different; e.g., opposing angles 180 degrees apart.

Depending on the structure of the metrology target 860, the scattered radiation may comprise reflected radiation, diffracted radiation or transmitted radiation. In this embodiment, the metrology target may be a diffraction-based overlay target; and each illumination beam may correspond to a scattered beam comprising at least one non-zeroth diffraction order. Each scattered beam carries information of the illuminated metrology target. For example, the first illumination beam 810 may correspond to the first scattered beam 811 comprising the positive first diffraction order $+1^{st}$ DF; the second illumination beam 820 may correspond to the second scattered beam 821 comprising the negative first diffraction order $-1^{st}$ DF. The zeroth diffraction order and other undesired diffraction orders may either be blocked by a beam blocking element (not shown) or configured to completely fall outside the NA of the objective lens 870. As a result, the df-DHM may be operated in a dark field mode. Note that, in some embodiments, one or more optical elements, e.g., a lens combination, may be used to achieve same optical effect of the objective lens 870.

Both scattered beams 811, 821 may be collected by objective lens 870 and subsequently re-focused onto an image sensor 880. Objective lens 870 may comprise multiple lenses, and/or df-DHM 800 may comprise a lens system having two or more lenses, e.g., an objective lens and an imaging lens, thereby defining a pupil plane of the objective lens between the two lenses and an image plane at the focus of the imaging lens. In this embodiment, a portion 812 of the first scattered beam 811 and a portion 822 of the second scattered beam 821 are simultaneously incident at a common position of the image sensor 880. At the same time, two reference beams of radiation, i.e. a first reference beam 830 and a second reference beam 840, are incident on the same position of the image sensor 880. Such four beams may be grouped into two pairs of scattered radiation and reference radiation. For example, the first scattered-reference beam pair may comprise the portion 812 of the first scattered beam 811 and the first reference beam 830. Likewise, the second scattered-reference beam pair may comprise the portion 822 of the second scattered beam 821 and the second reference beam 840. These two scattered-reference beam pairs may subsequently form two interference patterns (holographic images) which at least partially overlap in spatial domain.

The characteristic of the structure of the metrology target 860 is determined by a processing unit 890 of the metrology apparatus. The processing unit 890 uses the first interference pattern and the second interference pattern recorded by the image sensor 880 to determine the characteristic of the structure of the metrology target 860.

In a scatterometry metrology tool, light may be used to create an image (e.g., at one or both of an image plane or pupil plane/angularly resolved plane) of a structure on a substrate. Such tools may measure the intensity or amplitude (or related measurement parameter such as diffraction efficiency) of the detected light, e.g., after having been scattered by the structure, and use this to determine one or more parameters of interest of the structure. In many cases, it may be beneficial to know the complex field (i.e., amplitude and phase) of the light scattered by the structure.

There are a number of present methods which enable the phase to be determined, in addition to the measured intensity/amplitude. One such technology is the aforementioned DHM, however holographic methods are typically subject to strict stability requirements and/or very low acquisition times, to suppress mechanical vibrations and/or drift and therefore achieve the necessary interference of the scattered radiation with reference radiation at the detector.

It can also be understood that building an interferometer using SXR wavelengths is technically much more challenging than using optical wavelengths. Light from the same source must be taken for the reference arm (which reduces the number of photons actually available for the measurements, thus reducing throughput). Also, the optics are much more expensive for SXR wavelengths than for optical wavelengths; reflective optics must be used with low reflection efficiencies and the requirements in terms of mechanical stability are much tighter.

Another known method comprises performing multiple measurements under various conditions (e.g., different focus levels) and reconstructing the complex field of the scattered light using an iterative algorithm (e.g. as described in WO2021/121733, incorporated herein by reference). However, such methods are computationally very demanding/expensive and can be slow as a consequence, particularly as the accuracy of the retrieved phase is required to be higher in metrology than for more conventional phase retrieval applications such as microscopy and which require only the formation of an image. Other technologies are also known such as using masks having a pinhole or similar aperture in the detection branch of the tool, which allows an interferometric measurement (e.g. as described in WO2020/254041, incorporated herein by reference).

A non-iterative method for determining the complex field of the scattered radiation will now be described, based on causality, such as which applies in the (one-dimensional) time versus angular frequency context. This time causality stems from the fact that the electric field cannot travel faster than the speed of light, leading to an electric field $E=Q$ for a time $t<0$ constraint. In other words, temporal causality means that in any physical system, the results of a given input excitation can never anticipate the excitation itself (i.e., no output is present before the input has excited the system).

This time/causality constraint leads to a symmetry relationship of the electric field in the angular frequency domain. This symmetry relation is often referred to as the (e.g., first) Kramers-Kronig relationship (and its inverse, which is the second Kramers-Kronig relationship). In an optical analogy of this concept, the time constraint may be replaced/implemented by locating a mask in the pupil plane (i.e., angularly resolved plane), such that the time coordinate $t$ becomes the pupil coordinate, and the angular frequency coordinate $\omega$ becomes the sensor/camera (image plane) coordinate. Because the Kramers-Kronig relationship comprises a linear integral transform (in essence a convolution operation), the (one-dimensional) Kramers-Kronig expression(s), expressed in terms of Fourier transforms, may be extended into a two-dimensional analysis; i.e., the two dimensions of the pupil plane/image plane.

Applying the Kramers-Kronig relationship to non-iteratively extract phase information, and therefore the full field, requires applying the phase extraction algorithm to an intensity image which is the result of an optical field having a single-sided spectrum. Typically, this may be achieved by filtering out one side of spectrum (e.g., with respect to the specular beam) using a physical mask within the pupil plane. For example, the pupil edge may be used as the mask, e.g., by centering the specular beam (or each diffracted/scattered beam of interest in a dark-field embodiment) on the pupil edge in the pupil plane such that the edge clips (i.e., blocks) half of the beam. Such methods are described, for example, in patent application WO2024056296A, which is incorporated herein by reference.

However, physically masking the beam is non-optimal as it limits applicability of Kramers-Kronig based methods using, for example, a setup such as that illustrated in Figure 5(a) to certain situations such as a limited usable $\lambda/p$ range (where $\lambda$ is the wavelength(s) of the measurement radiation used and $p$ is the target pitch) and/or limited coherence conditions for the measurement radiation and/or requires the provision of a dedicated mask in the pupil plane (which is not desirable).

Methods and apparatuses which do not require a physical mask have been described. However, these require bright-field imaging; i.e., capturing of the zeroth diffraction order (specular reflection). Capturing the zeroth diffraction order results in such methods being particularly sensitive for vibrations (e.g., vibration of the substrate stage compared to the optical column). This vibration sensitivity is caused by the zeroth diffraction order having a significant angle with respect to the first order diffraction order. It can also be appreciated that this vibration issue also applies to DHM, where instead of the zeroth order, a reference beam is captured. It is this reference beam which has a significant angle with respect to the first order diffraction, leading to the vibration sensitivity.

Therefore, methods and apparatuses which enable non-iterative phase extraction (or at least non-iterative extraction of a related quantity such as the phase derivative or phase magnitude derivative from which the phase can be determined) in dark-field metrology, for which the zeroth order is not captured (e.g., it is blocked or at least attenuated before detection) are described herein. However, it should be understood that these concepts are also usable in, and applicable to, bright-field metrology.

Alternatively or in addition, methods and apparatuses which enable improved non-iterative phase extraction in SXR metrology, e.g., using a metrology apparatus as described in relation to Figure 6, are also disclosed herein.

In each case, the methods disclose obtaining measurement data relating to (e.g., describing an intensity of) at least one component of scattered radiation, having been scattered by a structure of interest (e.g., a target), determining a derivative of the phase of each said at least one component of said scattered radiation from said intensity, and determining at least one parameter of interest from said derivative of the phase. The at least one component may comprise one or more higher (e.g., non-zero) diffraction orders. Optionally, the at least one component may also comprise a zeroth order.

Briefly, WO2024056296A describes measuring intensity of one or more (mostly) single-sided spectra, and processing these to retrieve (part of) the complex optical field coming from the target, using phase retrieval relation:

$$\varphi(x) = \mathcal{H}\{\log|E(x)|\} \qquad [1],$$

where $\mathcal{H}\{\}$ signifies a Hilbert transform, $\varphi(x)$ is the retrieved phase from electric field modulus (amplitude) $|E(x)|$, and $x$ signifies the position in the detection plane (i.e., the camera pixel position).

However, because the logarithm of zero equals minus infinity, and the complex logarithm is not invertible leading to phase wrapping/winding issues, this phase retrieval relation [1] is not practically applicable or useable in dark-field sensing.

Therefore, it is proposed to instead perform a phase gradient (i.e., phase derivative) modulus retrieval rather than a direct phase retrieval. According to a 1-dimensional dispersion analysis example, the phase gradient modulus $\left|\frac{\partial\varphi(x)}{\partial x}\right|$ may be retrieved using the following relationship:

$$\left|\frac{\partial\varphi(x)}{\partial x}\right| = \frac{1}{2}\cdot\frac{1}{|E(x)|^2}\cdot\left|\mathcal{H}\left\{\frac{\partial|E(x)|^2}{\partial x}\right\}\right| \qquad [2]$$

where $|E(x)|^2$ is the detected intensity.

It can be appreciated, and demonstrated mathematically, that Equation [2] and Equation [1] are mathematically consistent. It can also be appreciated that Equation [2] may be rewritten in a convenient form for retrieving the phase from the determined phase derivative:

$$\left|\frac{\partial\varphi(x)}{\partial x}\right| = \frac{1}{2}\cdot\frac{1}{|E(x)|^2}\cdot\left|\frac{\partial\mathcal{H}\{|E(x)|^2\}}{\partial x}\right| \qquad [3]$$

The reason that only the absolute value of the phase gradient is determined by the expression [2], [3] is that there are two solutions (a first solution from a first or left side of the pupil mask, and a twin solution or conjugate solution from a second or right side of the pupil mask. The pupil mask consists of two edges, but using both edges simultaneously does not lead to an informative dispersion relation. Because of this, only one edge may be used, but there is no way of discerning whether it should be the left or right edge. This is accommodated the equations [2], [3] by adding the absolute value operator(s). This results in an additional twin solution (similar to holography). Combining the solution and its twin results in only being able to determine the magnitude of the phase gradient, but not the sign.

The sign may be determined when stitching the phase gradient, as will be described below. When 'stitching' the phase derivatives (to be more precise the absolute values thereof), into the phase, an iterative algorithmic step may be employed. As such, determining the absolute value of the phase derivatives is non-iterative, while the subsequent stitching may be iterative.

This phase gradient modulus retrieval expression [2], [3] is well suited for application in both bright-field and dark-field sensing applications. In dark-field sensing, such as detected on detector 23 of the apparatus of Figure 5(a), only one diffraction order, or a pair of diffraction orders, is typically captured (although more may be). This means that dark-field sensing is much less sensitive for vibrations (vibration of the wafer stage compared to the optical column). The low vibration sensitivity of dark-field sensing emerges from a much smaller cone of k-space angles which contributes to the image.

Therefore, this phase gradient modulus retrieval expression [2], [3] makes it possible for phase retrieval to be performed on an apparatus such as illustrated by Figure 5(a), without any significant hardware changes which would be required to capture the zeroth diffraction order and to solve the vibration issue caused by capturing the zeroth order. The only hardware change which may be required is that the detector (camera) pixel pitch should be sufficiently small (e.g., the effective camera pixel pitch at wafer level may be comparable to that of DHM) to compute accurate derivatives of the measured intensity. For example, the pixel pitch may be twice as dense in one direction (and therefore four times as dense in two-dimensions) than is required from only an optical resolution limit perspective. Also, the dynamic range of the camera may be sufficiently large to prevent intensity clipping (i.e., the dynamic range should be sufficient to prevent clipping of the brightest intensity pixel), as clipping impacts the accuracy of phase retrieval.

The proposed methods in this example assumes scalar diffraction, which is accurate when the numerical aperture (NA) at camera level is small (i.e., the NA at camera level is comparable to DHM), but this assumption of scalar diffraction is not essential and an extension to full vectorial diffraction can be made. However, a relatively small illumination numerical aperture (e.g., such that the partial coherent imaging is not incoherent and preferably close to coherent) may be chosen when retrieving the phase.

The phase gradient modulus retrieval expression [2], [3] may be used for coherent or partial coherent illumination. The fact that partial coherent illumination can still be used means that the illumination hardware of present devices such as illustrated in Figure 5(a) can still be used. Partial coherence can be used because, in the partial coherent case (for example due to finite bandwidth and/or due to a non-zero illumination numerical aperture), the retrieved phase derivative is a weighted average of all coherent contributions (coherent contribution conforms to a Sum Of Coherent Systems (SOCS) decomposition). By contrast, Equation [1] assumes coherent illumination.

It can be appreciated that a zero in the intensity is much less problematic for equation [2], [3] as it is in phase retrieval equation [1]. In equation [1], a zero affects the retrieved phase for all positions, while for equation [2], [3] any position $x$ for which the intensity is zero can simply be ignored when integrating / wrapping /stitching to extract the phase from the calculated phase derivative. The absence of the logarithm function in equation [2], [3] compared to equation [1] means that equation [2], [3] takes its information from only the bright intensity areas. This is because zero intensities do not (significantly) contribute to Hilbert transform, while for equation [1] the logarithm of a zero amplitude equals minus infinity, and hence a zero intensity will have a large impact on Hilbert transform. Therefore equation [2], [3] does not suffer from phase wrapping/winding issues. It is because of this, that equation [2], [3] may be applied in both bright-field and dark-field sensing applications, while equation [1] can only be practically applied for bright-field sensing applications.

As is the case with other phase retrieval algorithms, the phase gradient modulus retrieval relation [2], [3] retrieves the so-called minimum phase only, and any all-pass filter contributions to the phase cannot be retrieved as they are not observable in a single intensity image. However, only three archetypes of all-pass filters exist: average phase offset (piston term Zernike 1), the linear phase ramp (linear phase ramp, Zernike 2 and Zernike 3, i.e., a shift of the pupil plane electric field) and Blaschke pole+zero pair(s). However, this is not problematic. It can be shown that Blaschke pole+zero pair(s) cannot occur in a diffraction limited optical system, while average phase offset has no impact on the signal(s) and the linear phase ramp only influences the position of the signal(s) in the pupil.

Note that the linear phase ramp will differ in between areas that are not electromagnetically coupled. Therefore, in images with large constant intensity (background) regions, multiple different linear phase ramps can be present.

The phase $\varphi(x)$ (excluding the average phase and linear phase ramp as described above) can for example be reconstructed/wrapped from the phase gradient / shear $\frac{\partial \varphi(x)}{\partial x}$ by solving a discrete and weighted version of Poisson's equation. Poisson's equation emerges from a finite difference computation of all derivatives to yield phase difference retrieval equation:

$$\lim_{x_1 - x_2 \downarrow 0} \left( \varphi(x_1) - \varphi(x_2) \right) = \frac{\mathcal{H}\{|E(x_1)|^2\} - \mathcal{H}\{|E(x_2)|^2\}}{|E(x_1)|^2 + |E(x_2)|^2} \qquad [4]$$

Therefore, extending this phase reconstruction / wrapping to the two-dimensional case, i.e. reconstructing the phase $\varphi(x, y)$ from two phase gradient / shears, for example $\frac{\partial \varphi(x,y)}{\partial x}$ and $\frac{\partial \varphi(x,y)}{\partial y}$ (or their moduli), is reasonably straightforward. Rewriting Equation [2], [3] in two-dimension form yields:

$$\left| \frac{\partial \varphi(x)}{\partial (\cos(\psi)x + \sin(\psi)y)} \right|$$

$$= -\frac{1}{2} \cdot \frac{1}{|E(x,y)|^2}$$

$$\cdot \left| \frac{\partial \mathcal{F}\left\{ \left( -i \cos(\psi)\mathrm{sgn}(k) - i \sin(\psi)\,\mathrm{sgn}(l) \right) \mathcal{F}^{-1}\{|E(x,y)|^2\} \right\}}{\partial(\cos(\psi)x + \sin(\psi)y)} \right|$$

$$= -\frac{1}{2} \cdot \frac{1}{|E(x,y)|^2} \cdot \left| \mathcal{F}\{|\cos(\psi)k + \sin(\psi)\,l|\, \mathcal{F}^{-1}\{|E(x,y)|^2\}\} \right| \qquad [5]$$

noting that $\mathcal{H}\{F(x)\} = \mathcal{F}\{-i\, \text{sgn}\,(k)\, \mathcal{F}^{-1}\{F(x)\}\}$ (and equivalent for the $y/l$ direction) where $\mathcal{F}\{\}$ signifies a Fourier transform, $k$ is a pupil coordinate in the $x$ direction, $l$ is a pupil coordinate in the $y$ direction and angle $\psi$ donates the shear direction.

To retrieve the two-dimensional phase phase $\varphi(x, y)$, the two-dimensional phase gradient retrieval equation [5] may be solved for two shear values, e.g., $\psi \in \{0°, 90°\}$. This specific choice yields:

$$2|E(x,y)|^2 \cdot \left| \frac{\partial \varphi(x,y)}{\partial x} \right| = \left| \frac{\partial \mathcal{F}\left\{ (i\, \text{sgn}\,(k))\, \mathcal{F}^{-1}\{|E(x,y)|^2\} \right\}}{\partial x} \right| \qquad [6a];$$

and

$$2|E(x,y)|^2 \cdot \left| \frac{\partial \varphi(x,y)}{\partial y} \right| = \left| \frac{\partial \mathcal{F}\left\{ (i\, \text{sgn}\,(l))\, \mathcal{F}^{-1}\{|E(x,y)|^2\} \right\}}{\partial y} \right| \qquad [6b]$$

Note that, per field plane position (x, y), there are two equations and three unknowns, i.e., the unknown phase $\varphi(x, y)$ and the two unknown signs due to the absolute value operators in Equation [6a] respectively Equation [6b]. The total number of unknowns for all field plane positions, may be reduced further, by taking into account, *inter alia,* the pupil stop aperture size and pupil stop shape (for example via a Gerschberg-Saxton like projection)."

It can also be appreciated that the left-hand side multiplication with intensity $|E(x, y)|^2$ in Equation [6a] and Equation [6b] is beneficial from a measurement noise weighting (e.g., signal to noise ratio) perspective. To further optimize this noise weighting, an additional weighting/scaling may be applied.

Alternatives to equation [5] are possible and may be used, e.g., based on computing the phase derivative via Fast Fourier Transforms.

At least some methods described herein may be used for example, in diffraction based metrology such as diffraction based overlay (DBO) or diffraction based focus (DBF) metrology. Diffraction based metrology such as DBO/DBF comprises comparing complementary diffraction orders (i.e., diffraction orders of the same order number either side of the specular beam such as the +1 and - 1 diffraction orders; i.e., diffraction orders having the same magnitude diffraction angle with respect to the specular beam) to determine an asymmetry in the scattering structure or target, from which a parameter of interest (e.g., overlay or focus) can be extracted. In terms of DBO, the concepts disclosed herein may be applied to microDBO ($\mu$DBO) where the gratings in each layer have the same pitch, or continuous DBO (cDBO), where the gratings in each layer have different pitches, the order of the gratings being reversed in two complementary targets. In each case, the proposed methods may be employed to retrieve the phase of each diffraction order. Alternatively, the methods described herein may be used to retrieve phase of a dark field (or bright field) image of the interference of the multiple higher diffraction orders, for example the first and second diffraction order, having interfered (at the detector).

A parameter of interest may be determined from a digitally processed local reconstructed field determined using the methods described herein. This step may comprise (digitally) reimaging the local reconstructed field for each diffraction order of interest, such as a pair of complementary diffraction orders, e.g., +1/-1 diffraction orders (optionally a pair of complementary diffraction orders per X and Y direction of the substrate plane)). The parameter of interest may then be determined (e.g., optionally per direction) from a comparison or difference of the diffraction order of each pair (e.g., comparing the +1 order and -1 order).

The proposed methods may be applied to the imaged diffraction orders to obtain the full-field description of these diffraction orders. As such, with the phase gradient, and therefore the phase, retrieved via Equation [2], [3] one or more of the following may be performed:

- Reduce coherent crosstalk (from surrounding to target and / or intra target) by means of filtering of the obtained image(s).
- Improve image quality by using the retrieved phase to minimize/reduce aberration.
- As an extension of the above, improve machine-to-machine matching by minimizing/reducing aberration differences between machines.
- Retrieve overlay (or focus) directly from the phase information (e.g., as an alternative to the aforementioned DBO/DBF methods)
- Improved and/or faster reconstruction of one or more parameters of interest defining a structure being measured.

Additionally, Equation [2], [3] and the concepts disclosed above can also be applied on pupil images (e.g.,

captured using the detector 19 in the apparatus of Figure 5(a)). As such, the concepts disclosed herein may be used for (e.g., overlay) In-Device Metrology (IDM). The additional phase information obtained using such techniques can help to improve IDM performance such as accuracy robustness, decorrelation of overlay inference, etc., without adding complex hardware, e.g. adding a reference arm as needed by interferometric IDM.

Additionally, Equation [2], [3] and the concepts disclosed above can also be applied on DHM images (i.e., scattered radiation interfered with reference radiation and therefore comprising a reference component), such as captured using a metrology device similar to that illustrated in Figure 8.

The basic concepts of determining a phase gradient from the detected intensity may also be used to improve SXR metrology using, for example, a metrology apparatus such as illustrated in Figure 6. Direct phase measurements (such as interferometry/holography) are currently not envisioned because they are technically challenging at SXR wavelengths (e.g., between 8-20nm or any of the other ranges described above) and may result in a notable increase of cost of goods.

Such SXR metrology tools may be developed for reconstructing one or more parameters of interest from a diffraction pattern captured on a detector (camera). However, without phase information of the measured diffraction patterns and input beam, direct reconstruction of the target is not possible, nor is it possible to determine a good starting point for recipe setup. Current model-based reconstructions require prior knowledge of the use case and a well calibrated tool. This approach is computational expensive and needs a good estimate of the probe in any case.

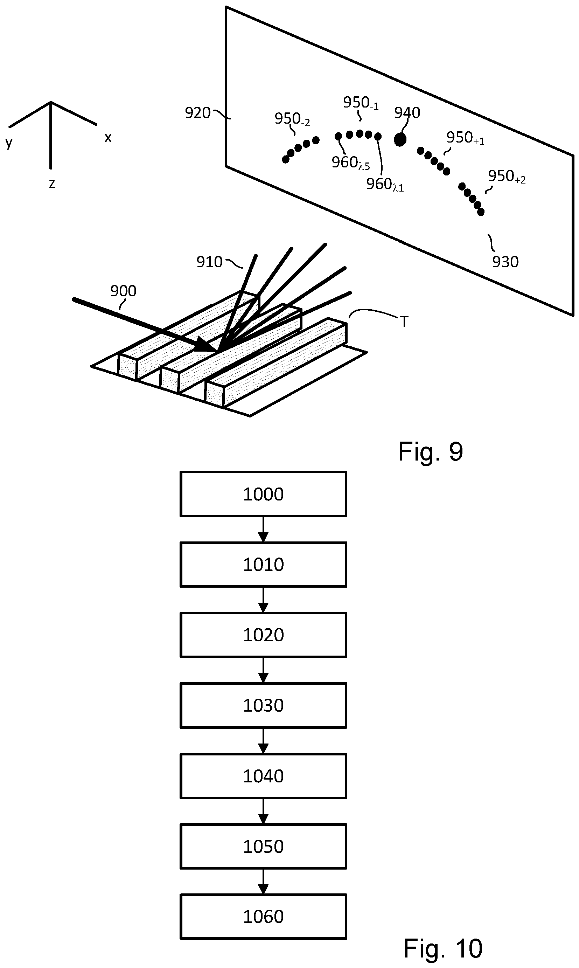

Figure 9 illustrates the geometry of a measurement using an SXR metrology tool as described. A broad-band, SXR incident beam 900 interacts with a structure of interest such as a periodic target T (represented by a 1D periodic diffraction grating in the Figure, although it may be any ideally periodic structure). A plurality of components of scattered radiation 910, e.g., a plurality of diffraction orders (e.g., including a zeroth order), is generated. A number of these diffraction orders will be captured on a detector 920; the actual number of diffraction orders captured will depend on target T pitch, detector geometry, incident beam 900 wavelengths etc.. In this specific illustrative example, the captured diffraction orders 930 on detector 920 comprise a zeroth order 940, a pair of first orders $950_{-1}$, $950_{+1}$ and a pair of second orders $950_{-2}$, $950_{+2}$ (i.e., where the subscript to label 950 identifies the respective higher order). The distance between target and detector is such that diffraction orders can be clearly separated from each other at detector level. It can be seen that each higher (i.e., non-zeroth) diffraction order forms multiple spots on the detector. For brevity, only two of these spots $960_{\lambda 1}$, $960_{\lambda 5}$, comprised within diffraction order $950_{-1}$, are labeled. Per diffraction order, each of these spots corresponds to a different wavelength due to the different individual harmonics present in the SXR incident beam 900 generated via e.g., HHG (as has been described). The actual number of harmonics in the SXR incident beam 900, and therefore the number of spots (diffraction order sub-components or replicas) per diffraction order may vary depending on the source characteristics. The intensity per wavelength is recorded for each (fully) detected diffraction order.

The expression of the vectorial and complex scattered field at detector plane can be derived by solving Maxwell equations. For the sake of simplicity, but without loss of generality, the following will consider 1D periodic targets (with assumed periodicity of period p along the x direction). For a given wavelength $\lambda$, the scattered field takes the expression:

$$\mathbf{A}(\mathbf{r}) = \sum_m \frac{i}{4\pi q_z^{(m)}} \left\{ \int_{z'} \mathbf{F}_m(z') \exp\left[i2\pi q_z^{(m)} z'\right] dz' \right\} \exp\left(i2\pi \underline{\mathbf{q}}^{(\mathbf{m})} \cdot \mathbf{r}\right) \qquad [7]$$

where $\mathbf{r}=(x,y,z)$, m is the diffraction order index, $\mathbf{A}(\mathbf{r})$ is the vector potential which is linked to the electric field through the relation:

$$\mathbf{E}(\mathbf{r}) = i\omega\mu_0 \mathbf{A}(\mathbf{r}) - \frac{1}{i\omega\varepsilon_0} \nabla\nabla \cdot \mathbf{A}(\mathbf{r}) \qquad [8]$$

while $\varepsilon_0$ and $\mu_0$ respectively indicate the electric permittivity and magnetic permeability of vacuum. For the sake of simplicity, the depolarization term $\frac{1}{i\omega\varepsilon_0} \nabla\nabla \cdot \mathbf{A}(\mathbf{r})$ may be neglected. In that case, the vector potential and the electric field are the same, other than a trivial multiplication factor. The concepts disclosed here are unaffected by this.

For convenience, the following quantities are defined:

$$\underline{\mathbf{q}}^{(\mathbf{m})} = \left(q_x^{(m)}, q_y^{(i)}, -q_z^{(m)}\right)$$

$$q_x^{(m)} = q_x^{(i)} + \frac{m}{p}$$

$$q_z^{(m)} = \sqrt{\frac{1}{\lambda^2} - \left(q_x^{(m)}\right)^2 - \left(q_y^{(i)}\right)^2}$$

$$\mathbf{q}^{(i)} = \left(q_x^{(i)}, q_y^{(i)}, q_z^{(i)}\right)$$

where p is the period of the target T, $\mathbf{q}^{(i)}$ is the incident wavevector (wavevector of the incident beam) comprising x, y and z components $q_x^{(i)}, q_y^{(i)}, q_z^{(i)}$ and m is the integer charactering the diffraction order under consideration.

It is convenient to define a field:

$$\mathbf{F(r)} = \Delta\varepsilon(\mathbf{r})\mathbf{E(r)} = \sum_m \mathbf{F}_m(z) \exp\left[i2\pi\frac{m}{p}x + i2\pi q_x^{(i)}x + i2\pi q_y^{(i)}y\right] \qquad [9]$$

where $\Delta\varepsilon(\mathbf{r})$ is the permittivity contrast with respect to vacuum ($\Delta\varepsilon(\mathbf{r}) = \varepsilon(\mathbf{r}) - 1$), $\mathbf{F}_m(z)$ are the Fourier coefficients, generally depending on z. The permittivity contrast $\Delta\varepsilon(\mathbf{r})$ is the "object" that is to be reconstructed.

This field $\mathbf{F(r)}$ may be seen as the "effective" object which also takes into account the spatial structure of the near field $\mathbf{E(r)}$. As such, field $\mathbf{F(r)}$ incorporates both the geometry of the target and the total field in the target.

It should be appreciated that that the z-component of the wavevector of the m-th diffraction order depends on the wavelength. Hence, for a fixed angle of incidence, the only way $q_z^{(m)}$ can be varied is by varying the wavelength, e.g., by using a broadband source.

For completeness, it can be appreciated that Equation [7] formally has a structure similar to the Born approximation (single scattering approximation) where the total near field $\mathbf{E(r)}$ in Equation [8] is replaced by the incident field $\mathbf{E}^{(i)}$ only.

The scattered field, for the Born approximation, can therefore be described by:

$$\mathbf{A(r)} = \sum_m \frac{i}{4\pi q_z^{(m)}} \left\{ \int_{z'} \Delta\varepsilon_m(z') \exp\left[i2\pi\left(q_z^{(i)} + q_z^{(m)}\right)z'\right] dz' \right\} \exp\left(i2\pi\mathbf{q}^{(m)} \cdot \mathbf{r}\right) \quad [10]$$

where the following is defined:

$$\Delta\varepsilon(\mathbf{r}) = \sum_m \Delta\varepsilon_m(z) \exp\left[i2\pi\frac{mx}{p}\right] \qquad [11]$$

From Equation [7] it can be seen that the far field is essentially obtained through a $z - q_z$ Fourier transform through 1D integration:

$$\tilde{\mathbf{F}}\left(q_z^{(m)}\right) = \int_{z'} \mathbf{F}_m(z') \exp\left[i2\pi q_z^{(m)}z'\right] dz' \qquad [12]$$

where the integral extends on all z values where the target exists.

This means that the field $\mathbf{F}_m(z)$ satisfies a sort of causality relation in z-space:

$$\mathbf{F}_m(z) = \mathbf{F}_m(z)u(z) \qquad [13]$$

where $u(z)$ is a Heaviside function defined as:

$$u(z) = \begin{cases} 1, z \geq 0 \\ 0, z < 0 \end{cases}$$

Because of Equation [13], the Kramers-Kronig relations between the real $\tilde{\mathbf{F}}_r\left(q_z^{(m)}\right)$ and the imaginary part

$\tilde{\mathbf{F}}_i\left(q_z^{(m)}\right)$ of the complex function $\tilde{\mathbf{F}}\left(q_z^{(m)}\right)$ are valid, i.e.:

$$\tilde{\mathbf{F}}_i\left(q_z^{(m)}\right) = \mathcal{H}\left\{\tilde{\mathbf{F}}_r\left(q_z^{(m)}\right)\right\} = \frac{1}{\pi}\int_{-\infty}^{\infty}\frac{\tilde{\mathbf{F}}_r\left(q_z^{(m)}\right)}{\xi - q_z^{(m)}}d\xi \qquad [14a]$$

$$\tilde{\mathbf{F}}_r\left(q_z^{(m)}\right) = \mathcal{H}\left\{\tilde{\mathbf{F}}_i\left(q_z^{(m)}\right)\right\} = -\frac{1}{\pi}\int_{-\infty}^{\infty}\frac{\tilde{\mathbf{F}}_i\left(q_z^{(m)}\right)}{\xi - q_z^{(m)}}d\xi \qquad [14b]$$

where it is defined:

$$\tilde{\mathbf{F}}\left(q_z^{(m)}\right) = \tilde{\mathbf{F}}_r\left(q_z^{(m)}\right) + i\tilde{\mathbf{F}}_i\left(q_z^{(m)}\right) \qquad [15]$$

and where $\xi$ is an integration variable having the same units as $q_z^{(m)}$

In practice, neither the real nor the imaginary part of $\tilde{\mathbf{F}}\left(q_z^{(m)}\right)$ is accessed, but rather its amplitude $\left|\tilde{\mathbf{F}}\left(q_z^{(m)}\right)\right|$, i.e., via the detected intensity after removal of the source spectrum (this will be described) which is the square of this amplitude.

It can be demonstrated that, under some conditions, a similar relation holds between the amplitude and the phase of $\tilde{\mathbf{F}}\left(q_z^{(m)}\right)$, for example:

$$\boldsymbol{\varphi}_{\tilde{\mathbf{F}}}\left(q_z^{(m)}\right) = \mathcal{H}\left\{\ln\left|\tilde{F}(\xi)\right|\right\} = \frac{1}{\pi}\int_{-\infty}^{\infty}\frac{\ln\left|\tilde{F}(\xi)\right|}{\xi - q_z^{(m)}}d\xi \qquad [16]$$

where $\boldsymbol{\varphi}_{\tilde{\mathbf{F}}}\left(q_z^{(m)}\right)$ is the phase of $\tilde{\mathbf{F}}\left(q_z^{(m)}\right)$ This in principle means that the phase can be retrieved from the detected signal.

As explained above, the only way the variable $\xi$ (i.e., $q_z^{(m)}$) can be varied is by using multiple wavelengths. Therefore Equation [16] practice can only be implemented in an approximate form:

$$\boldsymbol{\varphi}_{\tilde{\mathbf{F}}}\left(q_z^{(m)}\right) = \frac{1}{\pi}\int_{\xi_{min}}^{\xi_{max}}\frac{\ln\left|\tilde{F}(\xi)\right|}{\xi - q_z^{(m)}}d\xi \qquad [17]$$

where:

$$\xi_{min} = \sqrt{\frac{1}{\lambda_{min}^2} - \left(q_x^{(i)}\right)^2 - \left(q_y^{(i)}\right)^2}$$

$$\xi_{max} = \sqrt{\frac{1}{\lambda_{max}^2} - \left(q_x^{(i)}\right)^2 - \left(q_y^{(i)}\right)^2}$$

Thus, the application of Kramers-Kronig relations to this specific z-q$_z$ transform presents difficulties because the estimate of Equation [16] via Equation [17] is inevitably inaccurate. One way to circumvent this issue is to use higher-order Kramers-Kronig relations. In fact, the main reason that Equation [17] provides a poor estimate of Equation [16] is the slow decaying of the 1/q kernel appearing in the integrand. By differentiating Equation [16] with respect to $q_z^{(m)}$ (and using

integration by parts), a similar Kramers-Kronig may be derived for the derivatives of the functions involved. This improves convergence of the integral (because the integral for the derivative kernel falls off as $1/q^2$). This leads to the following high-order Kramers-Kronig in terms of the phase derivative:

$$\frac{d\varphi_{\tilde{F}}\left(q_z^{(m)}\right)}{dq_z^{(m)}} = \frac{1}{\pi}\int_{\xi_{min}}^{\xi_{max}}\frac{d\left|\tilde{F}(\xi)\right|}{d\xi}\frac{1}{\tilde{F}(\xi)}\frac{1}{\left(\xi - q_z^{(m)}\right)}\,d\xi \qquad [18]$$

Because the integration in Equation [18] converges faster than the integral in Equation [16], given the measured data available, the derivative of the phase can be estimated more accurately than the phase itself. Note also, Equation [18] determines the actual phase derivative rather than only its magnitude, as with equation [2], [3]. This is because the metrology setup described in Figure 6 provides for only one-sided time causality, rather than the ambiguity arising from the two mask edges.

In principle, higher-order Kramers-Kronig relations can be obtained by differentiating Equation [16] more than once.

Once the derivative of the phase is retrieved, a 1D integration of Equation [18] may be performed to obtain the phase (up to an additive constant).

Figure 10 is a flowchart describing a method which uses Equation [18] in an SXR metrology context, e.g., using a metrology apparatus as illustrated in Figure 6.

At step 1000, a structure of interest (target) is illuminated by a broadband SXR probe. This may be achieved by using a HHG source operating in the spectral range from ~ 8nm to 20 nm. It is assumed that the target occupies a finite region of space: i.e., (x,y,z>0) space. In practice, this condition is always met.

At step 1010, the intensity of diffraction pattern produced by the interaction of the incident SXR probe with the target is recorded. The assumption is that, when measuring periodic targets at detector level, the diffraction patterns per each diffraction order can be separated.

At step 1020. the HHG source spectrum is removed from the intensity signal recorded at step 1010 to obtain the diffraction efficiencies of the target, per measured diffraction order, as a function of the wavelength. Because the spectral power spectrum of the HHG source consists of many separate harmonics (it has a frequency comb-like structure), this operation may be denoted as "uncombing" of the signal. More specifically, the source spectral power as a function of wavenumber may comprise a comb-like shape, where wavenumber is the reciprocal of wavelength. Essentially this step aims to remove the influence of the source spectrum on the recorded signal to leave only the contribution due to the target of interest. Methods of source spectrum removal are described, for example, in WO2023169818A1, which is incorporated herein by reference. As such, these methods will not be described in detail here. Other method of determining or measuring the source spectrum may be used instead.

Briefly, WO2023169818A1 describes estimating the source spectrum from the diffraction pattern using the target as a spectrometer. The source spectrum is estimated as a distance spectrum in distance space where distance in this context is the Fourier conjugate of the wavenumber. As such, this distance spectrum is Fourier transformed from a wavenumber spectrum in wavenumber space. For example, the source spectrum may be approximated as the product of an infinite comb spectrum and a smooth envelope spectrum. Step 1020 may therefore comprise the sub-steps of transforming the measured spectrum from the wavenumber domain to the distance domain, constructing a comb distance spectrum from peaks of the measured spectrum in said distance domain and transforming the comb distance spectrum to a comb wavenumber spectrum in the wavenumber domain. The estimate of the source spectrum may comprise the comb wavenumber spectrum divided by an envelope wavenumber spectrum.

At step 1030, the intensity signal of the diffraction efficiency of the measured m-th diffraction order is converted into function $I\left(q_z^{(m)}\right) = \left|\tilde{F}\left(q_z^{(m)}\right)\right|^2$ where $m$ is an integer denoting the diffraction order and $q_z^{(m)}$ is a function of the wavelength. The assignment of a signal recorded by the detector to a specific diffraction order may be performed, for example, once the pitch(es) of the targets are known, along with the angle of incidence the SXR beam upon the target and the position of the image sensor relative to the target (see for example the aforementioned WO2023169818A1 or in WO2021/121906A1 which is incorporated herein by reference).

At step 1040, An estimate of the derivative of the phase of the signal is determined from the measured intensity signal of each diffraction order. This step may comprise applying Equation [18] to the measured intensity signal of each diffraction order separately.

At step 1050, the derivative of the signal obtained in step 1040 is integrated to obtain the phase (up to a constant which is not relevant because phase is defined up to an additive constant).

At step 1060, the phase (and amplitude) is used to obtain one or more parameters of interest such as overlay, CD, layer thicknesses and/or any other dimension and/or angle of a structure.

Step 1060 may comprise performing an inverse transform from $q_z$ to z space. This would provide a low-pass version of the corresponding Fourier component of the near-field. With phase information available, the features of this near-field are now positioned at absolute depth inside the target (and not at relative distance, like in an autocorrelation method where such phase information is not available). This means that depth-filtering/weighting (namely selecting/emphasizing a particular subdomain in z) are possible. In fact, once the complex quantity $\tilde{\mathbf{F}}\left(q_z^{(m)}\right)$ is known, it is possible invert Equation [12] and obtain a representation of $\mathbf{F}_m(z)$. Equation [9] can then be used to obtain a representation of the field $\mathbf{F}(\mathbf{r})$ of the unit cell of the target, and therefore of the target itself. With a representation of field $\mathbf{F}(\mathbf{r})$ available, it is possible to identify parts of the domain of field $\mathbf{F}(\mathbf{r})$ that are likely to be affected by the parameters of interest and less affected by other nuisance parameters or parameters of non-interest (for example, in some situations, CD could be a parameter of interest while layer thickness is a parameter of nuisance or non-interest).

Step 1060 may comprise a multiplication of the result with a spatial mask that is nonzero only at the aforementioned identified parts to obtain a filtered representation (FR) of the sample response, which will have a reduced impact of parameters of non-interest. Step 1060 may also comprise applying an inverse Fourier transform to obtain another FR in $(m, q_z)$ space. A data-driven inference or model-based reconstruction may be performed on one of these FRs. For example, a model may be trained using a training set of FRs; the trained model could then be used for inference on data not used for training.

In model-based reconstruction methods, the full complex field could be used directly in model-based reconstruction, instead of using only the intensity. Since all cost functions used in literature (L2, L1 norms) are non-linear in the input data, the shape of the cost function in the parameter space will change with and without phase information.

Depth filtering at absolute distances in the target enabled by the phase information, potentially further enables the phase information to reduce/remove the need for a global optimization step in model-based reconstruction. Since the global optimization is time consuming, this would have beneficial impact on a product. In this case one could replace calling a global optimizer with multiple, and parallel, local optimizations on the z-filtered sub-spaces. Alternatively, after having filtered the near-field with a spatial mask in target space (i.e., in x,y,z space), the signal could be transformed back to detector space and the filtered signal used at detector level for model-based reconstruction. In this way phase information would help pre-condition the search for the optimum while removing the influence of nuisance parameters.

In summary, for all the embodiments described above, having access to the full field profile (both amplitude and phase) enables computational methods for, for example, any one or more of: beam propagation, aberration corrections, feature extraction by z depth filtering (depth filtering methods for selecting $\Delta z$ ranges, i.e., ranges in a direction perpendicular to the substrate plane, are described in WO2021/121906), and/or 3D direct tomographic reconstruction. Additionally, accessing the full complex-value field could also lead to direct benefits in model-based reconstruction.

Using the concepts disclosed herein it is possible to perform non-iterative phase retrieval in dark-field or bright-field imaging. In addition, the concepts disclosed herein enable the use of partial coherent illumination, and/or SXR radiation. This opens the applicability of such methods to a broader range of light sources, such as the ones currently used in many metrology devices.

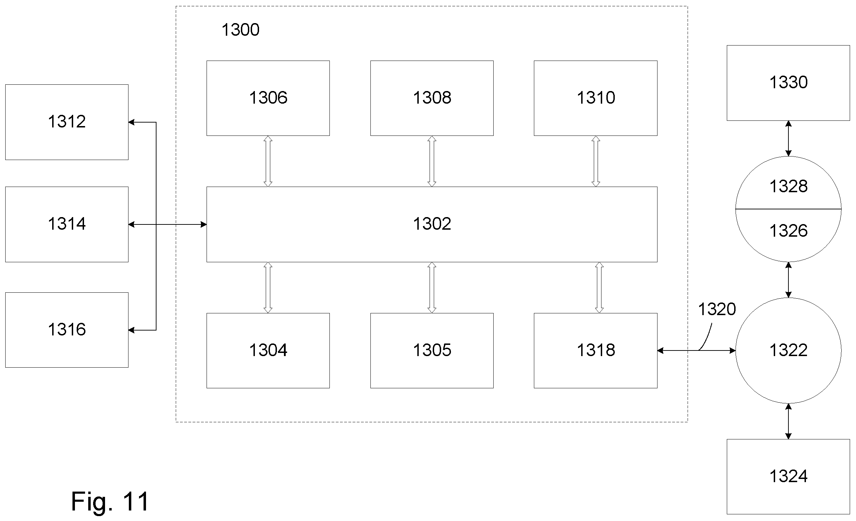

Figure 11 is a block diagram that illustrates a computer system 1300 that may assist in implementing the methods and flows disclosed herein. Computer system 1300 includes a bus 1302 or other communication mechanism for communicating information, and a processor 1304 (or multiple processors 1304 and 1305) coupled with bus 1302 for processing information. Computer system 1300 also includes a main memory 1306, such as a random access memory (RAM) or other dynamic storage device, coupled to bus 1302 for storing information and instructions to be executed by processor 1304. Main memory 1306 also may be used for storing temporary variables or other intermediate information during execution of instructions to be executed by processor 1304. Computer system 1300 further includes a read only memory (ROM) 1308 or other static storage device coupled to bus 1302 for storing static information and instructions for processor 1304. A storage device 1310, such as a magnetic disk or optical disk, is provided and coupled to bus 1302 for storing information and instructions.

Computer system 1300 may be coupled via bus 1302 to a display 1312, such as a cathode ray tube (CRT) or flat panel or touch panel display for displaying information to a computer user. An input device 1314, including alphanumeric and other keys, is coupled to bus 1302 for communicating information and command selections to processor 1304. Another type of user input device is cursor control 1316, such as a mouse, a trackball, or cursor direction keys for communicating direction information and command selections to processor 1304 and for controlling cursor movement on display 1312. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1300 in response to processor 1304 executing one or more sequences of one or more instructions contained in main memory 1306. Such instructions may be read into main memory 1306 from another computer-readable medium, such as storage device 1310. Execution of the sequences of instructions contained in main memory 1306 causes processor 1304 to perform the process steps described herein. One or more processors in a multi-processing arrangement may also be employed to execute the sequences of instructions contained in main memory 1306. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1304 for execution. Such a medium may take many forms, including but not limited to, non-volatile media, volatile media, and transmission media. Non-volatile media include, for example, optical or magnetic disks, such as storage device 1310. Volatile media include dynamic memory, such as main memory 1306. Transmission media include coaxial cables, copper wire and fiber optics, including the wires that comprise bus 1302. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1304 for execution. For example, the instructions may initially be borne on a magnetic disk of a remote computer. The remote computer can load the instructions into its dynamic memory and send the instructions over a telephone line using a modem. A modem local to computer system 1300 can receive the data on the telephone line and use an infrared transmitter to convert the data to an infrared signal. An infrared detector coupled to bus 1302 can receive the data carried in the infrared signal and place the data on bus 1302. Bus 1302 carries the data to main memory 1306, from which processor 1304 retrieves and executes the instructions. The instructions received by main memory 1306 may optionally be stored on storage device 1310 either before or after execution by processor 1304.

Computer system 1300 also preferably includes a communication interface 1318 coupled to bus 1302. Communication interface 1318 provides a two-way data communication coupling to a network link 1320 that is connected to a local network 1322. For example, communication interface 1318 may be an integrated services digital network (ISDN) card or a modem to provide a data communication connection to a corresponding type of telephone line. As another example, communication interface 1318 may be a local area network (LAN) card to provide a data communication connection to a compatible LAN. Wireless links may also be implemented. In any such implementation, communication interface 1318 sends and receives electrical, electromagnetic or optical signals that carry digital data streams representing various types of information.

Network link 1320 typically provides data communication through one or more networks to other data devices. For example, network link 1320 may provide a connection through local network 1322 to a host computer 1324 or to data equipment operated by an Internet Service Provider (ISP) 1326. ISP 1326 in turn provides data communication services through the worldwide packet data communication network, now commonly referred to as the "Internet" 1328. Local network 1322 and Internet 1328 both use electrical, electromagnetic or optical signals that carry digital data streams. The signals through the various networks and the signals on network link 1320 and through communication interface 1318, which carry the digital data to and from computer system 1300, are exemplary forms of carrier waves transporting the information.

Computer system 1300 may send messages and receive data, including program code, through the network(s), network link 1320, and communication interface 1318. In the Internet example, a server 1330 might transmit a requested code for an application program through Internet 1328, ISP 1326, local network 1322 and communication interface 1318. One such downloaded application may provide for one or more of the techniques described herein, for example. The received code may be executed by processor 1304 as it is received, and/or stored in storage device 1310, or other non-volatile storage for later execution. In this manner, computer system 1300 may obtain application code in the form of a carrier wave.

Further embodiments have been disclosed in the following list of numbered clauses:

1. A method of metrology comprising:

obtaining measurement data relating to scattered radiation, having been scattered by a structure of interest and captured on at least one detector;
determining at least a magnitude of a derivative of the phase of at least one component of said scattered radiation from said intensity; and
determining at least one parameter of interest of said structure of interest from said at least the magnitude of the derivative of the phase.

2. A metrology method as defined in clause 1, comprising using a Kramers-Kronig based algorithm to retrieve said at least the magnitude of the derivative of the phase of at least one component.
3. A metrology method as defined in clause 1 or 2, wherein said determining at least the magnitude of the derivative of the phase of at least one component comprises determining a Hilbert transform of a derivative of an intensity of the at least one component or a derivative of the Hilbert transform of the intensity of the at least one component.

4. A metrology method as defined in clause 3, comprising determining the phase of said at least one component from said at least the magnitude of the derivative of the phase by solving a weighted variant and/or discrete version of Poisson's equation.

5. A metrology method as defined in any preceding clause, comprising determining the phase in two-dimensions from a retrieval equation for said at least the magnitude of the derivative of the phase, solved for two shear directions.

6. A metrology method as defined in any preceding clause, wherein said at least one component comprises one or more non-zero diffraction orders.

7. A metrology method as defined in any preceding clause, wherein said scattered radiation, as captured on at least one detector, comprises a zeroth order component.

8. A metrology method as defined in any of clauses 1 to 6, wherein said scattered radiation, as captured on at least one detector, does not comprise a zeroth order component or comprises an attenuated zero order component.

9. A metrology method as defined in any preceding clause, wherein said scattered radiation, as captured on at least one detector, comprises a reference beam component.

10. A metrology method as defined in any preceding clause, wherein said determining step comprises determining the magnitude of the derivative of the phase.

11. A metrology method as defined in clause 10, further comprising the additional step of determining the sign of said derivative of the phase.

12. A metrology method as defined in any of clauses 1 to 9, wherein said determining step comprises directly determining the derivative of the phase from said intensity.

13. A metrology method as defined in any preceding clause, wherein said obtaining said metrology data comprises:

illuminating the periodic structure with said illumination; and
capturing said scattered radiation from said periodic structure as a result of said illuminating at a detection plane.
comprising performing a measurement to obtain said measurement data.

14. A metrology method as defined in clause 13, comprising detecting said scattered radiation at an image plane.

15. A metrology method as defined in clause 13, comprising detecting said scattered radiation at an angularly resolved plane.

16. A metrology method as defined in any preceding clause, wherein said at least one diffraction order comprises at least a pair of complementary diffraction orders.

17. A metrology method as defined in any preceding clause, wherein each said one or more non-zero diffraction orders comprises a plurality of diffraction orders, each said diffraction order comprising a plurality of sub-component, each sub-component relating to a different wavelength.

18. A metrology method as defined in clause 17, comprising an initial step of removing a source spectrum from said measurement data to obtain diffraction efficiency data.

19. A metrology method as defined in clause 18, comprising converting, per diffraction order,

said diffraction efficiency data into an intensity signal data which is a quantity which is a function of wavelength and the wave vector of an incident beam, which is incident on said structure of interest to generate said scattered radiation; and
transforming said diffraction efficiency data to obtain said at least the magnitude of the derivative of the phase .

20. A metrology method as defined in any preceding clause, comprising integrating said at least the magnitude of the derivative of the phase to obtain the phase.

21. A metrology method as defined in any preceding clause, wherein said determining the at least the magnitude of the derivative of the phase is performed non-iteratively.

22. A metrology method as defined in any preceding clause, wherein said scattered radiation comprises broadband radiation.

23. A metrology method as defined in clause 22, wherein said broadband radiation comprises radiation generated via high harmonic generation.

24. A metrology method as defined in clause 22 or 23, wherein said broadband radiation comprises wavelengths between 8nm and 20nm.

25. A metrology method as defined in any preceding clause, wherein said scattered radiation comprises coherent radiation.

26. A metrology method as defined in any preceding clause, wherein said scattered radiation comprises partially coherent radiation.

27. A metrology method as defined in any preceding clause, wherein said parameter of interest is one or more of overlay, focus, a layer thickness, a wall angle, substrate height and/or any dimensional parameter of said structure of interest.

28. A metrology method as defined in any preceding clause, comprising using said at least the magnitude of the derivative of the phase to estimate one or more parameters of interest in a reconstruction of said structure of interest.

29. A metrology method as defined in clause 28, wherein said using the at least the magnitude of the derivative of the phase to estimate one or more parameters of interest, comprises using the at least the magnitude of the derivative of the phase to estimate initial values for said one or more parameters of interest prior to further reconstruction steps.

30. A metrology method as defined in clause 28 or 29, comprising using said at least the magnitude of the derivative to define at least one sub-space comprising a range, in a direction perpendicular to a substrate plane defined by the substrate, within which to estimate and/or for weighting an estimation of one or more of said one or more parameters of interest.

31. A metrology method as defined in in any preceding clause, wherein said metrology data comprises intensity data.

32. A computer program comprising program instructions operable to perform the method of any of clauses 1 to 31, when run on a suitable apparatus.

33. A non-transitory computer program carrier comprising the computer program of clause 32.

34. A processing device comprising:

a processor; and
the non-transitory computer program carrier of clause 33.

35. A metrology apparatus being operable to perform the method of any of clauses 1 to 31.

36. A metrology apparatus comprising the processing device of clause 34.

37. A lithographic cell comprising:

a lithographic apparatus operable to apply a pattern to a substrate; and
the processing device according to clause 34 and/or the metrology apparatus according to clause 35 or 36.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method of metrology comprising:

   obtaining measurement data relating to scattered radiation, having been scattered by a structure of interest and captured on at least one detector;
   determining at least a magnitude of a derivative of the phase of at least one component of said scattered radiation from said intensity; and
   determining at least one parameter of interest of said structure of interest from said at least the magnitude of the derivative of the phase.

2. A metrology method as claimed in claim 1, comprising using a Kramers-Kronig based algorithm to retrieve said at least the magnitude of the derivative of the phase of at least one component.

3. A metrology method as claimed in claim 1 or 2, wherein said determining at least the magnitude of the derivative of the phase of at least one component comprises determining a Hilbert transform of a derivative of an intensity of the at least one component or a derivative of the Hilbert transform of the intensity of the at least one component.

4. A metrology method as claimed in claim 3, comprising determining the phase of said at least one component from said at least the magnitude of the derivative of the phase by solving a weighted variant and/or discrete version of Poisson's equation.

5. A metrology method as claimed in any preceding claim, comprising determining the phase in two-dimensions from a retrieval equation for said at least the magnitude of the derivative of the phase, solved for two shear directions.

6. A metrology method as claimed in any preceding claim, wherein said determining step comprises determining the magnitude of the derivative of the phase.

7. A metrology method as claimed in claim 6, further comprising the additional step of determining the sign of said derivative of the phase.

8. A metrology method as claimed in any of claims 1 to 5, wherein said determining step comprises directly determining the derivative of the phase from said intensity.

9. A metrology method as claimed in any preceding claim, wherein said obtaining said metrology data comprises:

   illuminating the periodic structure with said illumination; and
   capturing said scattered radiation from said periodic structure as a result of said illuminating at a detection plane.
   comprising performing a measurement to obtain said measurement data.

10. A metrology method as claimed in any preceding claim, wherein each said one or more non-zero diffraction orders comprises a plurality of diffraction orders, each said diffraction order comprising a plurality of sub-component, each sub-component relating to a different wavelength.

11. A metrology method as claimed in claim 10, comprising an initial step of removing a source spectrum from said measurement data to obtain diffraction efficiency data.

12. A metrology method as claimed in claim 11, comprising converting, per diffraction order,

   said diffraction efficiency data into an intensity signal data which is a quantity which is a function of wavelength and the wave vector of an incident beam, which is incident on said structure of interest to generate said scattered radiation; and

transforming said diffraction efficiency data to obtain said at least the magnitude of the derivative of the phase .

13. A metrology method as claimed in any preceding claim, wherein said scattered radiation comprises broadband radiation.

14. A metrology method as claimed in claim 13, wherein said broadband radiation comprises radiation generated via high harmonic generation.

15. A metrology apparatus being operable to perform the method of any of claims 1 to 14.

Fig. 1

Fig. 2

Fig. 3

Fig. 4

Fig. 5

Fig. 6

Fig. 7

Fig. 8

Fig. 9

Fig. 10

Fig. 11

Europäisches
Patentamt

European
Patent Office

Office européen
des brevets

# EUROPEAN SEARCH REPORT

**Application Number**

EP 24 21 0525

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 527 242 B2 (GRANOT ER EL [IL]; STERNKLAR SHMUEL [IL] ET AL.) 3 September 2013 (2013-09-03) | 1-3,6-9, 13,15 | INV. G03F7/00 |
| Y | * column 5, line 3 - column 24, line 51 * * figure 6 * ----- | 4,5, 10-12,14 | |
| Y | US 11 619 884 B2 (ASML NETHERLANDS BV [NL]) 4 April 2023 (2023-04-04) | 4,5 | |
| A | * column 17, line 11 - column 25, line 42 * ----- | 1,15 | |
| Y | EP 4 242 744 A1 (ASML NETHERLANDS BV [NL]) 13 September 2023 (2023-09-13) | 10-12,14 | |
| A | * paragraph [0046] - paragraph [0114] * * figure 10 * ----- | 1,15 | |

| | |
|---|---|
| | **TECHNICAL FIELDS SEARCHED (IPC)** |
| | G03F |

The present search report has been drawn up for all claims

| Place of search | Date of completion of the search | Examiner |
|---|---|---|
| Munich | 21 March 2025 | Meixner, Matthias |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

     .......................................................................................
& : member of the same patent family, corresponding
document

EPO FORM 1503 03.82 (P04C01)

ANNEX TO THE EUROPEAN SEARCH REPORT
ON EUROPEAN PATENT APPLICATION NO.

EP 24 21 0525

This annex lists the patent family members relating to the patent documents cited in the above-mentioned European search report.
The members are as contained in the European Patent Office EDP file on
The European Patent Office is in no way liable for these particulars which are merely given for the purpose of information.

21-03-2025

| Patent document cited in search report | | Publication date | Patent family member(s) | | Publication date |
|---|---|---|---|---|---|
| US 8527242 | B2 | 03-09-2013 | EP | 2247940 A2 | 10-11-2010 |
| | | | US | 2011022328 A1 | 27-01-2011 |
| | | | WO | 2009098694 A2 | 13-08-2009 |
| US 11619884 | B2 | 04-04-2023 | CN | 113168121 A | 23-07-2021 |
| | | | CN | 118151498 A | 07-06-2024 |
| | | | EP | 3663856 A1 | 10-06-2020 |
| | | | KR | 20210076995 A | 24-06-2021 |
| | | | TW | 202038003 A | 16-10-2020 |
| | | | US | 2022050387 A1 | 17-02-2022 |
| | | | US | 2023244151 A1 | 03-08-2023 |
| | | | WO | 2020114729 A1 | 11-06-2020 |
| EP 4242744 | A1 | 13-09-2023 | CN | 118843835 A | 25-10-2024 |
| | | | EP | 4242744 A1 | 13-09-2023 |
| | | | IL | 314999 A | 01-10-2024 |
| | | | KR | 20240159935 A | 07-11-2024 |
| | | | TW | 202400985 A | 01-01-2024 |
| | | | WO | 2023169818 A1 | 14-09-2023 |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1
- US 20190107781 A
- WO 2021121733 A1
- WO 2021121733 A
- WO 2020254041 A
- WO 2024056296 A
- WO 2023169818 A1
- WO 2021121906 A1
- WO 2021121906 A

**Non-patent literature cited in the description**

- **LEMAILLET et al.** Intercomparison between optical and X-ray scatterometry measurements of FinFET structures. *Proc. of SPIE*, 2013, 8681